Europäisches Patentamt

European Patent Office

Office européen des brevets

(11) Veröffentlichungsnummer: **0 445 654 A1**

# EUROPÄISCHE PATENTANMELDUNG

(21) Anmeldenummer: **91102979.1**

(22) Anmeldetag: **27.02.91**

(51) Int. Cl.5: **H01L 21/00**

(30) Priorität: **05.03.90 CH 687/90**

(43) Veröffentlichungstag der Anmeldung:
**11.09.91 Patentblatt 91/37**

(84) Benannte Vertragsstaaten:
**CH DE FR GB IT LI**

(71) Anmelder: **T E T TECHNO INVESTMENT TRUST SETTLEMENT**
**C/o IPR Management Services AG, Schloss Strasse 73**
**FL-9490 Vaduz(LI)**

(72) Erfinder: **Sawatzki, Harry**
**Heiligkreuz 12**
**FL-9490 Vaduz(LI)**

(74) Vertreter: **Hotz, Klaus, Dipl.-El.-Ing. / ETH**
**Ruchacherstrasse**
**CH-8914 Aeugst a.A.(CH)**

(54) **Vorrichtung zum Halten und Positionieren einer Substratkassette.**

(57) Die Vorrichtung umfasst eine Positioniereinheit, die speziell für das Halten von Waferkassetten (1) geeignet ist. Die planeinstellbare Kassettenaufnahme besteht dabei aus einer auf einem Gehäuse (10) angeordneten Grundplatte (11) und darüber befestigter Kassettenauflageplatte (12). Ueber entsprechende Auflagekugelschrauben (17, 18, 19) kann die Kassettenauflageplatte höhenverstellt und niveliert werden. Das Einsetzen der Kassette (1) ist über Führungskufen (29, 30) leicht einleitbar und wird durch elektrische Schalter (20, 21) quittiert.

Fig. 1

Die Erfindung betrifft eine Vorrichtung zum Halten und Positionieren einer Substratkassette, insbesondere Waferkassette in Wafer-Bearbeitungs- und/oder Inspektions-Einrichtungen.

Substratkassetten dienen zum Tarnsport und der Lagerung von Substraten wie Wafern, Glasplatten, Harddisks, u.s.w. Die Substrate werden in den Kassetten so gehalten, dass die Oberflächen der Substrate weder durch die Kassettenauflageflächen noch durch deren benachbart abgelegte Substratplatten berührt werden können.

Solche Substratkassetten haben ein breites Anwendungsgebiet in der heutigen Halbleiterindustrie. Bei Systemen, die solche Substratplatten verarbeiten und/oder inspizieren, muss dafür gesorgt werden, dass die Substrate problemlos aus den Substratkassetten entnommen werden können, bzw. die Substratplatten nach einer Bearbeitung bzw. Inspektion automatisch wieder in vorbereitete Substratkassetten ablegen zu können.

Um daher eine genau definierte Position der Substrate in einem Bearbeitungssystem voraussetzen zu können, muss sich die Substratkassette in einem solchen System auf einfache Art möglichst exakt haltern lassen, sowie gegebenenfalls gemäss angestrebter Lage positionieren lassen. d.h. ein Operator einer Inspektions-Einrichtung muss in der Lage sein möglichst schnell eine vorgesehene Position einer Kassette einzustellen.

Bestehende Substratkassetten-Auflagen haben den Nachteil meistens keine präzise Positionierung der Substrat-Kassetten zu erlauben. Zudem ist besonders bei Substrat-Kassetten-Auflagen, die die Aufnahme von Substrat-Kassetten verschiedener Grössen erlauben, das Finden der einmal einzunehmenden Grundposition schwierig und umständlich.

Bei manchen Substrat-Kassetten-Auflagen ist es sogar möglich, die zu platzierenden Substrat-Kassetten falsch zu positionieren, was gegebenenfalls beim automatischen Zugriff eines Inspektions-Systems auf eine Substratplatte in einer solchen Kassette zur Beschädigung von Substratplatte und/oder Kassette führen kann.

Zudem sind die Ablegerahmen in solchen Substrat-Kassetten meist so gestaltet, dass die Substratplatten nach deren Ablage in der Kassette eine gegen die Rückwand der Kassette abfallende Stellung einnehmen, denn dadurch versucht man zu verhindern, dass beim Transport solchen Substrat- und/oder Wafer-Kassetten die eigentlich zu haltenden Substrate oder Wafers ganz aus der Kasssette oder wenigstens bezüglich der Vorderkante überstehend aus der Kassette heraus rutschen. Die bezüglich der Rückwand abfallende Stellung hat also beim Transport durchaus die erwünschte Funktion.

Andererseits sollte ein Bearbeitungssystem oder eine Inspektionseinrichtung in der Lage sein, einen einmal erkannten Wafer automatisch aus einer solchen Wafer-Kassette auszulagern und zu bearbeiten bzw. zu inspizieren. Das bedeutet, dass der Wafer nach erfolgreicher Detektion beispielsweise durch ein automatisches, berührungsloses Erkennungssystem, die Oberfläche des Wafers problemlos überfahrbar sein. Dies ist aber mit Schwierigkeiten steuertechnischer Art verbunden, wenn sich beispielsweise das Handlingsystem während der Ueberfahrung dauernd absenken muss, oder aber ein Roboterarm eines solchen Handlingsystems in einer bestimmten Winkelstellung in die Kassette eintauchen muss, was übermässig Platz beansprucht.

Es ist daher Aufgabe der vorliegenden Erfindung, eine Vorrichtung der eingangs erwähnten Art zu schaffen, bei der eine möglichst einfache und sichere Grundpositionierung einer Substratkassette, insbesondere Waferkassette, erreicht werden kann und die dann durch systemgerechte Nachjustierungen in eine vorzuwählende Arbeitsposition bringen lassen.

Zur Lösung der Aufgabe ist eine Vorrichtung der eingangs genannten Art erfindungsgemäss dadurch gekennzeichnet, dass zur Aufnahme der Substrat-, insbesondere der Wafer-Kassette, eine Aufnahmeplatte vorgesehen ist, die mit einem mehrteiligen Führungssystem verbunden ist, wobei die Aufnahmeplatte zwei senkrecht zur Platte verlaufende Führungskufen aufweist, in die die Basiskufen der zu haltenden Kassette in der Arbeitsstellung eingetaucht sind und wobei die senkrecht auf der Aufnahmeplatte befestigte Bolzen für den Kassettenrahmen eine seitliche- und eine Verdrehsicherung darstellen.

Die zuvor erwähnte Bolzenarretierung hat insbesondere den Vorteil, dass damit der Quersteg am Kassettenboden einfach in bezug auf die Basiskufen eingestellt werden kann und über einen zusätzlichen Führungsstift in Höhe des Querstegs ausserhalb der Bodenführung der Kassette kann die Seitenstabilität erreicht werden.

Ein Ausführungsbeispiel der Erfindung wird im folgenden unter Bezugnahme auf die Zeichnungen näher beschrieben. Es zeigen:

Fig. 1    Eine Gesamtdarstellung einer Wafer-Inspektions-Einrichtung mit zwei Wafer-Kassetten;

Fig. 2    eine Detaildarstellung aus Fig. 1 mit einer erfindungsgemäss eingesetzten Wafer-Kassette;

Fig. 3    ein Ausschnitt aus einer Wafer-Inspektions-Einrichtung mit einer Seitenansicht der Wafer-Kassette;

Fig. 4    eine Aufsicht auf eine erfindungsgemäss gestaltete Aufnahmeplatte einer Wafer-Inspektions-Einrichtung.

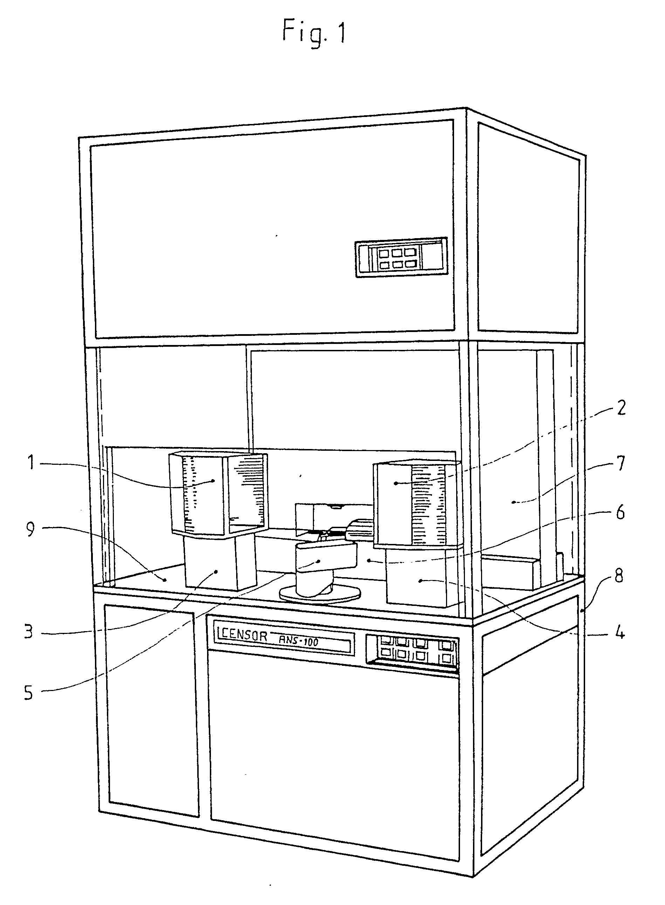

**Fig. 1** zeigt ein Substrat-Oberflächen-Inspektionsgerät wie es hauptsächlich zur Inspektion von Wafers zur Anwendung kommt. Neben kleinsten Partikeln können mit solchen Einrichtungen Kristallfehler, metallische Verunreinigungen, Polierfehler, Kratzer, Implantationsinhomogenitäten und andere Effekte an Wafern und Substraten visualisiert werden.

Das Gerät weist eine Waferinspektionseinrichtung mit einer ersten Waferkassette 1 und einer zweiten Waferkassette 2 auf, die auf einer ersten Kassettenaufnahme 3 und einer zweiten Kassettenaufnahme 4 stehend angeordnet sind.

Die Wafer-Inspektions-Einrichtung weist ferner einen Handlingroboter 5 und einen Inspektionstisch 6 auf. Aus konstruktiven Gründen ist dieser Inspektionstisch 6 starr mit der Konsole 7, der Tischplatte 9 und dem Chasis 8 verbunden. Um eine präzise Uebergabe von Wafern auch zu gewährleisten, muss der Roboter 5 zum Messtisch 6 ausgerichtet werden.

Die Position der ersten Waferkassette 1 und der zweiten Waferkassette 2 wird andererseits über entsprechende Messvorrichtungen über die erste Kassettenaufnahme 3 und die zweite Kassettenaufnahme 4 aufgenommen.

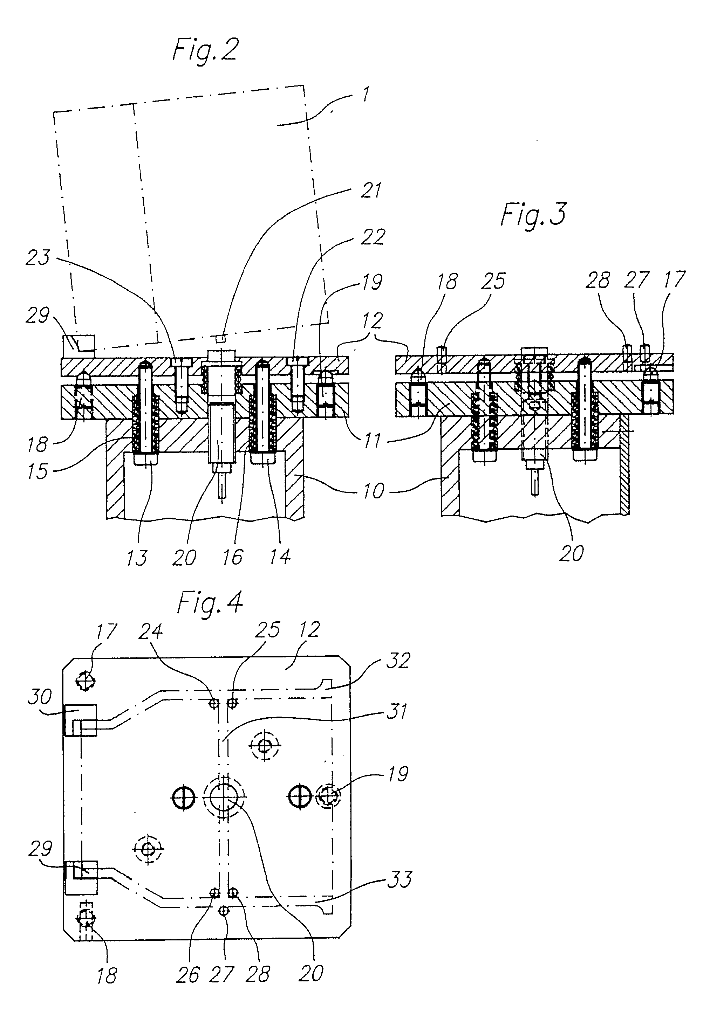

**Fig. 2 - 4** zeigen ein Ausführungsbeispiel einer einstellbaren Kassettenaufnahme. Die Kassettenaufnahme besteht aus einem Gehäuse 10 und einer Grundplatte 11 und einer Kassettenauflageplatte 12. Die Kassettenauflageplatte 12 wird von zwei Federn 15 und 16 über zwei Schrauben 13 und 14 gegen verstellbare Auflagekugelschrauben 17, 18 und 19 gepresst. Mit den Auflagekugelschrauben kann die Kassettenauflageplatte 12 höhenverstellt und nivelliert werden.

Nach der Justage wird die Position der Kassettenauflageplatte 12 über die Kleemschrauben 22 und 23 fixiert. Die Kassettenauflageplatte 12 weist einen Schalter 20 auf, der durch einen Mittelsteg 21 der Waferkassette 1 betätigbar ist. Dieser Schalter ist so ausgelegt, dass er bereits auf leichtes Anheben der Waferkassette 1 anspricht.

Die Waferkassette 1 wird einseitig durch drei Arretierbolzen 26, 27 und 28 und anderenseitig durch zwei Arretierbolzen 24 und 25 und durch zwei Führungskufen 29 und 30 geführt und gehalten. Die Führungskufen 29 und 30 sind so gestaltet, dass sie beim Aufsetzen der Waferkassette 1 eine Vorpositionierung bewirken. Dies ist realisiert, dadurch dass die Führungskufen 29 und 30 eine trichterformähnliche Gestaltung aufweisen.

Beim Aufsetzen weist die Waferkassette 1 eine leicht nach hinten geneigte Lage auf. Die Vorpositionierung durch die Führungskufen 29 und 30 ist nun so, dass beim Vorkippen der Kassetten die genaue Positionierung der Waferkassetten von den Arretierbolzen 24 und 28 übernommen werden kann.

Im aufgesetzten Zustand werden die Randleisten 32 und 33 und der Quersteg 31 zur Führunge der Waferkassette 1 in den Arretierbolzen 24 bis 28 verwendet.

Die Verwendung von drei Arretierbolzen 26, 27 und 28 bewirken zusammen mit der Randleiste 33 und dem Quersteg 31 eine einseitige Basisfixierung der Waferkassette 1. Die Arretierbolzen 24 und 25 bewirken eine Verdrehsicherheit der Waferkassette 1.

## Patentansprüche

1. Vorrichtung zum Halten und Positionieren einer Substratkassette, insbesondere einer Waferkassette in Wafer-Bearbeitungs- und/oder Inspektions-Einrichtungen, mit einer Aufnahmeplatte, die auf einer Führungsplatte angeordnet ist,
   **dadurch gekennzeichnet,** dass
   die Aufnahmeplatte mit einem mehrachsigen Führungssystem verbunden ist, zwei senkrecht zur ihrer Hauptausdehnung verlaufende Kufenaufnahmen aufweist, in die die Führungskufen der Waferkassette in der Arbeitsstellung eingetaucht sind, und wobei senkrecht auf der Aufnahmeplatte Arretierbolzen vorgesehen sind, durch die sich Randleisten des Kassettenbodens in der Arbeitsstellung fixieren lassen.

2. Vorrichtung zum Halten und Positionieren einer Substratkassette, insbesondere einer Waferkassette, nach Anspruch 1,
   **dadurch gekennzeichnet,** dass
   fünf Arretierbolzen vorgesehen sind, wobei vier in jeweils paarweiser Gegenüberstellung in den Bereichen wo der Quersteg der Randleiste des Kassettenbodens den Längssteg trifft, angeordnet sind und ein Arretierbolzen im gleichen Bereich, aber ausserhalb der Randleiste des Kassettenbodens in Längsrichtung vorgesehen ist.

3. Vorrichtung zum Halten und Positionieren einer Substratkassette, insbesondere einer Waferkassette, nach einem der vorangehenden Ansprüche,
   **dadurch gekennzeichnet,** dass
   die Führungsplatte Mittel zur Dreipunktlagerung der Aufnahmeplatte aufweist, wobei diese Dreipunktlagerung so ausgeführt ist, dass je ein Punkt als Loch-, Schlitz- und als Flächenlagerung erscheinen.

4. Vorrichtung zum Halten und Positionieren einer Substratkassette, insbesondere einer Waferkassette, nach einem der vorangehenden Ansprüche,
**dadurch gekennzeichnet,** dass
die Aufnahmeplatte in ihrem Zentrum eine Kassetten-Erkennungs-Einrichtung aufweist, über die eine einstellbare automatische Höhenanpassung der Waferkassette über das Führungssystem der Aufnahmeplatte aktivierbar ist.

# Fig. 1

EP 0 445 654 A1

*Fig.2*

*Fig.3*

*Fig.4*

6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 624 839 (RECIF)<br>* Seite 3, Zeile 26 - Seite 4, Zeile 27; Ansprüche 1, 3, 4; Figuren 1, 2, 4 *<br><br>– – – | 1 | H 01 L 21/00 |
| A | IBM TECHNICAL DISCLOSURE BULLETIN. vol. 28, no. 11, April 1986, NEW YORK US Seiten 4753 - 4754; "Universal Wafer-Boat-Alignment Fixture."<br>* das ganze Dokument *<br><br>– – – – – | 1 | |
| | | | **RECHERCHIERTE SACHGEBIETE (Int. Cl.5)**<br><br>H 01 L |

Der vorliegende Recherchenbericht wurde für alle Patentansprüche erstellt

| Recherchenort | Abschlußdatum der Recherche | Prüfer |
|---|---|---|
| Den Haag | 31 Mai 91 | RIEUTORT A.S. |